# EUROPÄISCHE PATENTSCHRIFT

(11) **EP 4 041 940 B1**
(45) Veröffentlichungstag und Bekanntmachung des Hinweises auf die Patenterteilung: **02.08.2023**
(21) Anmeldenummer: 20772273.7
(22) Anmeldetag: 15.09.2020
(51) Int. Cl.: C30B 15/30, C30B 29/06

(54) **VORRICHTUNG UND VERFAHREN ZUM ZIEHEN EINES EINKRISTALLS AUS HALBLEITERMATERIAL**
DEVICE AND METHOD FOR PULLING A SINGLE CRYSTAL OF SEMICONDUCTOR MATERIAL
DISPOSITIF ET PROCÉDÉ DE TIRAGE D'UN MONOCRISTAL DE MATÉRIAU SEMI-CONDUCTEUR

(30) Priorität: 10.10.2019 DE 102019215575
(43) Veröffentlichungstag der Anmeldung: 17.08.2022
(73) Patentinhaber: Siltronic AG, 81677 München (DE)
(72) Erfinder: SCHMID, Rolf, 84513 Töging (DE); BERGMANN, Helmut, 84524 Neuötting (DE); JÖDECKE, Werner, 8810 Horgen (CH)
(74) Vertreter: Staudacher, Wolfgang
(86) Internationale Anmeldenummer: PCT/EP2020/075732
(87) Internationale Veröffentlichungsnummer: WO 2021/069179

(56) Entgegenhaltungen:
- EP-A1- 0 466 457
- CN-A- 107 664 174
- CN-Y- 201 241 197

## Beschreibung

Gegenstand der Erfindung ist eine Vorrichtung zum Ziehen eines Einkristalls aus Halbleitermaterial aus einer Schmelze, die in einem Tiegel enthalten ist, sowie ein Verfahren zum Ziehen eines Einkristalls aus Halbleitermaterial, im Zuge dessen die Vorrichtung verwendet wird.

### Stand der Technik / Probleme

Einkristalle aus Halbleitermaterial werden häufig gemäß der CZ-Methode hergestellt, in deren Verlauf ein an einem Keimkristall wachsender Einkristall von einer Schmelze, die in einem Tiegel enthalten ist, weg nach oben gezogen wird. In industriellem Maßstab werden insbesondere Einkristalle aus Halbleitermaterial wie Silizium auf diese Weise hergestellt, um sie im Anschluss zu Halbleiterscheiben und später zu elektronischen Bauelementen weiterzuverarbeiten.

Eine Vorrichtung zum Anwenden der CZ-Methode umfasst in der Regel einen Tiegel, der von einer heb- und absenkbaren Tiegelwelle gehalten wird und eine heb- und absenkbare Ziehwelle, mit deren Hilfe der wachsende Einkristall von der Schmelze weggezogen wird. Des Weiteren umfasst eine solche Vorrichtung unter anderem jeweils eine Einrichtung zum Drehen der Ziehwelle und zum Drehen der Tiegelwelle. Einkristallines Wachstum erfordert eine möglichst erschütterungsfreie Umgebung, weshalb den Einrichtungen zur Ausführung der Drehbewegungen der Ziehwelle und der Tiegelwelle eine besondere Bedeutung zukommt.

In EP 0 466 457 A1 ist eine Vorrichtung gezeigt, bei der die Einrichtung zum Drehen der Ziehwelle einen Motor umfasst, der ein Zahnrad antreibt, welches in ein Schneckenrad eingreift, das an der Ziehwelle befestigt ist. Die Einrichtung zum Drehen der Tiegelwelle umfasst einen Motor, der die Tiegelwelle direkt antreibt.

Eine solche Vorrichtung genügt den heutigen Ansprüchen hinsichtlich des Bereitstellens einer möglichst erschütterungsfreien Umgebung nicht mehr.

Insbesondere ist nicht gewährleistet, dass vergleichsweise langwellige Schwingungen ausreichend unterdrückt werden.

Aufgabe der vorliegenden Erfindung ist es, eine Vorrichtung und ein Verfahren zum Ziehen von Einkristallen aus Halbleitermaterial bereitzustellen, wobei die Einrichtungen der Vorrichtung zum Drehen der Ziehwelle und der Tiegelwelle derart gestaltet sind, dass ein erschütterungsarmer Betrieb dieser Einrichtungen gewährleistet ist.

Die Aufgabe der Erfindung wird gelöst durch eine Vorrichtung zum Ziehen eines Einkristalls aus Halbleitermaterial aus einer Schmelze, die in einem Tiegel enthalten ist, mit einer Einrichtung zum Drehen einer Ziehwelle und mit einer Einrichtung zum Drehen einer Tiegelwelle, gekennzeichnet durch ein zweifaches Schneckengetriebe zwischen einem Antrieb und der Ziehwelle und durch ein weiteres zweifaches Schneckengetriebe zwischen einem weiteren Antrieb und der Tiegelwelle.

Die Vorrichtung löst nicht nur die Aufgabe, sondern stellt auch eine platzsparende und wartungsfreundliche Lösung dar, um die Drehung der Ziehwelle und der Tiegelwelle zu bewirken. Die beiden zweifachen Schneckengetriebe zeichnen sich durch ein vergleichsweise geringes Spiel und durch vergleichsweise ausgeprägte Laufruhe aus. Langwellige Schwingungen, die insbesondere durch niedrige Drehzahlen der Tiegelwelle von weniger als 1 U/min und/oder in Folge von einem Wechsel der Drehrichtung der Tiegelwelle hervorgerufen werden können, werden wirksam unterdrückt.

Die Erfinder haben herausgefunden, dass zwischen der Ziehwelle und den sie in Drehung versetzenden Antrieb beziehungsweise zwischen der Tiegelwelle und den sie in Drehung versetzenden weiteren Antrieb jeweils ein zweifaches Schneckengetriebe montiert sein muss. Bei einer solchen Anordnung hat der jeweilige Antrieb, vorzugsweise ein Elektromotor, dessen Welle die erste Schnecke des jeweiligen zweifachen Schneckengetriebes antreibt, eine Position seitlich der Drehachse der Ziehwelle (beziehungsweise seitlich der Drehachse der Tiegelwelle) mit ausreichend Abstand zur jeweiligen Drehachse. Vorzugsweise wird der jeweilige Antrieb starr auf einer Gehäuseplatte des jeweiligen zweifachen Schneckengetriebes befestigt. Eine federnde Lagerung des jeweiligen Antriebs ist also nicht vorgesehen. Die Welle des jeweiligen Antriebs ist vorzugsweise parallel zur Ziehwelle (beziehungsweise Tiegelwelle) angeordnet. Die erste Schnecke des jeweiligen zweifachen Schneckengetriebes greift in ein jeweiliges erstes Schneckenrad ein, welches koaxial auf der Welle der zweiten Schnecke des jeweiligen zweifachen Schneckengetriebes befestigt ist. Die zweite Schnecke des jeweiligen zweifachen Schneckengetriebes greift wiederum in das jeweilige zweite Schneckenrad des jeweiligen zweifachen Schneckengetriebes ein, wobei das jeweilige zweite Schneckenrad koaxial auf der Ziehwelle (beziehungsweise Tiegelwelle) befestigt ist.

Des Weiteren ist bevorzugt, die Ziehwelle beziehungsweise die Tiegelwelle jeweils in einen oberen und einen unteren Abschnitt zu gliedern und die beiden Abschnitte jeweils über einen Kupplungsbalg zu verbinden. Darüber hinaus ist zumindest im Fall der Ziehwelle der Kupplungsbalg derart ausgeführt, dass er den oberen Abschnitt der Ziehwelle vom unteren Abschnitt der Ziehwelle elektrisch isoliert. Das ermöglicht ein einfaches Implementieren der Detektion der Oberfläche der Schmelze über einen Stromkreis der den unteren Abschnitt der Tiegelwelle umfasst.

Der Antrieb der Tiegelwelle ist vorzugsweise derart ausgebildet, dass auch eine Umkehr der Drehrichtung der Tiegelwelle bewirkt werden kann.

Die Erfindung wird nachfolgend unter Bezugnahme auf zwei Zeichnungen weiter erläutert.

### Kurzbeschreibung der Figuren

Fig. 1 zeigt im Sinne eines Beispiels eine Vorrichtung zum Ziehen eines Einkristalls nach der CZ-Methode, die zur Verwirklichung der Erfindung genutzt werden kann.
Fig. 2 zeigt Merkmale einer erfindungsgemäßen Vorrichtung.

### Liste der verwendeten Bezugszeichen

**1** Einkristall
**2** Kammer
**3** Wärmedämmstoff
**4** Gaseinlass
**5** Gasauslass
**6** Heizung
**7** Schmelze
**8** Tiegel
**9** Gehäuseplatte
**10** Vorrichtung zum Ziehen
**11** wachsender Einkristall
**12** Stützeinrichtung
**13** Tiegelwelle
**14** Ziehwelle
**15** Halteeinrichtung
**16** Keimkristallhalter
**17** Keimkristall
**18** Magnetfelderzeugungsspule
**19** Steuerung
**20** Einrichtung zum Drehen der Ziehwelle
**21** Einrichtung zum Drehen der Tiegelwelle
**22** Antrieb
**23** Antriebswelle
**24** erste Schnecke
**25** erstes Schneckenrad
**26** zweite Schnecke
**27** zweites Schneckenrad
**28** oberer Abschnitt der Ziehwelle
**29** unterer Abschnitt der Ziehwelle
**30** Balgkupplung
**31** weiterer Antrieb
**32** weitere Antriebswelle
**33** weitere erste Schnecke
**34** weiteres erstes Schneckenrad
**35** weitere zweite Schnecke
**36** weiteres zweites Schneckenrad
**37** unterer Abschnitt der Tiegelwelle
**38** oberer Abschnitt der Tiegelwelle
**39** weitere Balgkupplung
**40** weitere Gehäuseplatte
**D** Drehachse

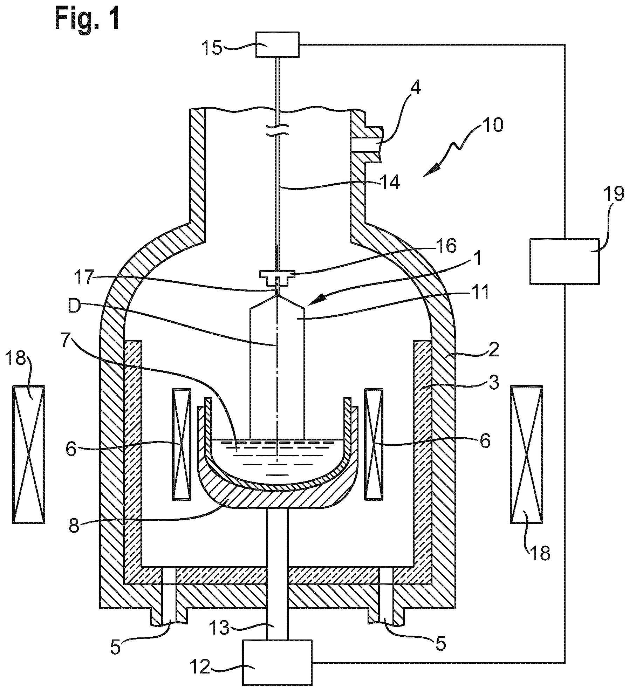

Fig. 1 zeigt im Sinne eines Beispiels eine Vorrichtung 10 zum Ziehen eines Einkristalls 1 aus Halbleitermaterial aus einer Schmelze 7, die erfindungsgemäß genutzt werden kann. Sie umfasst eine Kammer 2, eine Heizung 6, einen Tiegel 8, eine Tiegelwelle 13, eine Ziehwelle 14 und eine Magnetfelderzeugungsspule 18 auf. Eine Innenwand der Kammer 2 ist mit einem Wärmedämmstoff 3 versehen. Im oberen Teil der Kammer 2 ist ein Gaseinlass 4 vorgesehen, durch den ein Inertgas wie Argon eingeleitet wird, und am unteren Teil der Kammer 2 ist ein Gasauslass 5 vorgesehen. Der Tiegel 8 stützt einen Innentiegel, der mit der Schmelze 7 aus Halbleitermaterial gefüllt ist. Um den Tiegel 8 herum ist die Heizung 6 vorgesehen, um festes Halbleitermaterial zu schmelzen und in geschmolzenem Zustand zu halten. Die Tiegelwelle 13 erstreckt sich von einem unteren Ende des Tiegels 8 zum Boden der Kammer und wird von einer Stützeinrichtung 12 gelagert. Die Tiegelwelle 13 kann durch die Stützeinrichtung 12 gedreht und angehoben und abgesenkt werden. Die Ziehwelle 14 wird am oberen Ende von einer Halteeinrichtung 15 gehalten und kann mit Hilfe der Halteeinrichtung 15 um eine Drehachse D gedreht und angehoben und abgesenkt werden. Die Stützeinrichtung 12 und die Halteeinrichtung 15 werden von einer Steuerung 19 gesteuert. Indem ein Strom durch die Magnetfelderzeugungsspule 18 geleitet wird, kann ein Magnetfeld, beispielsweise ein horizontales Magnetfeld, der Schmelze 7 aufgeprägt werden. Darüber hinaus kann auch ein Hitzeschild (ist in der Abbildung nicht dargestellt) um den wachsenden Einkristall 11 angeordnet sein. Die Bezugszahlen 16 und 17 bezeichnen einen Keimkristallhalter und einen Keimkristall.

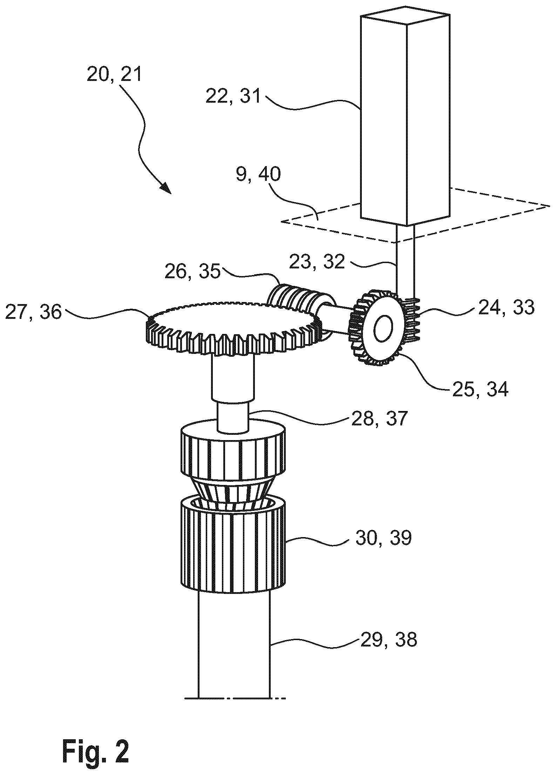

Entsprechend der Darstellung gemäß Fig.2 umfasst die Halteeinrichtung 15 eine Einrichtung 20 zum Drehen der Ziehwelle 14 und die Stützeinrichtung 12 eine Einrichtung 21 zum Drehen der Tiegelwelle 13. Die Einrichtungen 20 und 21 sind erfindungsgemäß ausgebildet.

Die Einrichtung 20 zum Drehen der Ziehwelle 14 umfasst einen Antrieb 22 mit einer Antriebswelle 23, die eine erste Schnecke 24 antreibt. Die erste Schnecke 24 greift in ein erstes Schneckenrad 25 ein, das koaxial an einer Welle einer zweiten Schnecke 26 fixiert ist. Die zweite Schnecke 26 greift in ein zweites Schneckenrad 27 ein, das koaxial an einem oberen Abschnitt 28 der Ziehwelle 14 fixiert ist. Die erste und zweite Schnecke 24, 26 und das erste und zweite Schneckenrad 25, 27 bilden gemeinsam ein zweifaches Schneckengetriebe. Der Antrieb 22 ist starr auf einer Gehäuseplatte 9 des zweifachen Schneckengetriebes befestigt. Zwischen dem oberen Abschnitt 28 der Ziehwelle 14 und einem unteren Abschnitt 29 der Ziehwelle 14 ist eine erste Balgkupplung 30 angeordnet, die den oberen Abschnitt 28 der Ziehwelle 14 vom unteren Abschnitt 29 der Ziehwelle 14 elektrisch isoliert.

Die Einrichtung 21 zum Drehen der Tiegelwelle 13 umfasst einen weiteren Antrieb 31 mit einer weiteren Antriebswelle 32, die eine weitere erste Schnecke 33 antreibt. Die weitere erste Schnecke 33 greift in ein weiteres erstes Schneckenrad 34 ein, das koaxial an einer Welle einer weiteren zweiten Schnecke 35 fixiert ist. Die weitere zweite Schnecke 35 greift in ein weiteres zweites Schneckenrad 36 ein, das koaxial an einem unteren Abschnitt 37 der Tiegelwelle 13 fixiert ist. Die weitere erste und zweite Schnecke 33, 35 und das weitere erste und zweite Schneckenrad 34, 36 bilden gemeinsam ein weiteres zweifaches Schneckengetriebe. Der weitere Antrieb 31 ist starr auf einer weiteren Gehäuseplatte 40 des weiteren zweifachen Schneckengetriebes befestigt. Zwischen dem unteren Abschnitt 37 der Tiegelwelle 13 und einem oberen Abschnitt 38 der Tiegelwelle 13 ist eine weitere Balgkupplung 39 angeordnet.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

## Patentansprüche

1. Vorrichtung zum Ziehen eines Einkristalls (1) aus Halbleitermaterial aus einer Schmelze (7), die in einem Tiegel (8) enthalten ist, mit einer Einrichtung (20) zum Drehen einer Ziehwelle (14) und mit einer Einrichtung (21) zum Drehen einer Tiegelwelle (13), **gekennzeichnet durch** ein zweifaches Schneckengetriebe zwischen einem Antrieb (22) und der Ziehwelle (14) und durch ein weiteres zweifaches Schneckengetriebe zwischen einem weiteren Antrieb (31) und der Tiegelwelle (13).

2. Vorrichtung nach Anspruch 1, **gekennzeichnet durch** eine Balgkupplung (30) zwischen einem oberen Abschnitt (28) und einem unteren Abschnitt (29) der Ziehwelle.

3. Vorrichtung nach Anspruch 1 oder Anspruch 2, **gekennzeichnet durch** eine weitere Balgkupplung (39) zwischen einem oberen Abschnitt (38) und einem unteren Abschnitt (37) der Tiegelwelle (13).

4. Vorrichtung nach einem der Ansprüche 1 bis 3, **dadurch gekennzeichnet, dass** eine Antriebswelle (23) des Antriebs (22) parallel zur Ziehwelle (14) angeordnet ist.

5. Vorrichtung nach einem der Ansprüche 1 bis 4, **dadurch gekennzeichnet, dass** der Antrieb (22) starr auf einer Gehäuseplatte (9) des zweifachen Schneckengetriebes befestigt ist.

6. Vorrichtung nach einem der Ansprüche 1 bis 5, **dadurch gekennzeichnet, dass** eine weitere Antriebswelle (32) des weiteren Antriebs (31) parallel zur Tiegelwelle (13) angeordnet ist.

7. Vorrichtung nach einem der Ansprüche 1 bis 6, **dadurch gekennzeichnet, dass** der weitere Antrieb (31) starr auf einer weiteren Gehäuseplatte (40) des weiteren zweifachen Schneckengetriebes befestigt ist.

8. Verfahren zum Ziehen eines Einkristalls aus Halbleitermaterial aus einer Schmelze gemäß der CZ-Methode, **gekennzeichnet durch** das Ziehen des Einkristalls aus Halbleitermaterial unter Verwendung einer Vorrichtung gemäß einem der Ansprüche 1 bis 7.

## Claims

1. Apparatus for pulling a single crystal (1) of semiconductor material from a melt (7) contained in a crucible (8), having a device (20) for rotating a pulling shaft (14) and having a device (21) for rotating a crucible shaft (13), **characterized by** a double worm gear between a drive (22) and the pulling shaft (14) and by a further double worm gear between a further drive (31) and the crucible shaft (13).

2. Apparatus according to Claim 1, **characterized by** a bellows coupling (30) between an upper portion (28) and a lower portion (29) of the pulling shaft.

3. Apparatus according to Claim 1 or Claim 2, **characterized by** a further bellows coupling (39) between an upper portion (38) and a lower portion (37) of the crucible shaft (13).

4. Apparatus according to any of Claims 1 to 3, **characterized in that** a driveshaft (23) of the drive (22) is arranged parallel to the pulling shaft (14).

5. Apparatus according to any of Claims 1 to 4, **characterized in that** the drive (22) is mounted rigidly on a housing plate (9) of the double worm gear.

6. Apparatus according to any of Claims 1 to 5, **characterized in that** a further driveshaft (32) of the further drive (31) is arranged parallel to the crucible shaft (13).

7. Apparatus according to any of Claims 1 to 6, **characterized in that** the further drive (31) is mounted rigidly on a further housing plate (40) of the further double worm gear.

8. Method for pulling a single crystal of semiconductor material from a melt by the CZ method, **characterized by** the pulling of the single crystal of semiconductor material using an apparatus according to any of Claims 1 to 7.

## Revendications

1. Appareil pour extraire un monocristal (1) de matériau semi-conducteur d'une matière fondue (7) contenue dans un creuset (8), comportant un dispositif (20) pour faire tourner un arbre d'extraction (14) et un dispositif (21) pour faire tourner un arbre de creuset (13), **caractérisé par** un double engrenage à vis sans fin entre un entraînement (22) et l'arbre d'extraction (14) et par un autre double engrenage à vis sans fin entre un autre entraînement (31) et l'arbre de creuset (13).

2. Appareil selon la revendication 1, **caractérisé par** un accouplement à soufflet (30) entre une partie supérieure (28) et une partie inférieure (29) de l'arbre de traction.

3. Appareil selon la revendication 1 ou la revendication 2, **caractérisé par** un autre accouplement à soufflet (39) entre une partie supérieure (38) et une partie inférieure (37) de la tige du creuset (13).

4. Appareil selon l'une des revendications 1 à 3, **caractérisé par le fait qu'**un arbre d'entraînement (23) de l'entraînement (22) est disposé parallèlement à l'arbre de traction (14).

5. Appareil selon l'une des revendications 1 à 4, **caractérisé par le fait que** l'entraînement (22) est monté rigidement sur une plaque de logement (9) de l'engrenage à double vis sans fin.

6. Appareil selon l'une des revendications 1 à 5, **caractérisé par le fait qu'**un autre arbre d'entraînement (32) de l'entraînement supplémentaire (31) est disposé parallèlement à l'arbre du creuset (13).

7. Appareil selon l'une des revendications 1 à 6, **caractérisé par le fait que** l'entraînement supplémentaire (31) est monté rigidement sur une plaque de logement supplémentaire (40) de l'engrenage à double vis sans fin supplémentaire.

8. Méthode d'extraction d'un monocristal de matériau semi-conducteur d'une matière fondue par la méthode CZ, **caractérisée par** l'extraction du monocristal de matériau semi-conducteur à l'aide d'un appareil selon l'une des revendications 1 à 7.
